# EUROPEAN PATENT APPLICATION

(11) **EP 4 517 348 A1**
(43) Date of publication of application: **05.03.2025**
(21) Application number: 22940269.8
(22) Date of filing: 28.04.2022
(51) Int. Cl.: G01R 31/26, G01R 31/28

(54) **SEMICONDUCTOR DIAGNOSTIC SYSTEM**

(71) Applicant: Hitachi Astemo, Ltd., Ibaraki 312-8503 (JP)
(72) Inventor: MASUBUCHI Takumi, Hitachinaka-shi, Ibaraki 312-8503 (JP); MIGITA Minoru, Hitachinaka-shi, Ibaraki 312-8503 (JP)
(74) Representative: Strehl Schübel-Hopf & Partner
(86) International application number: PCT/JP2022/019418
(87) International publication number: WO 2023/209996

(57) **Abstract**

To achieve a low-cost semiconductor diagnostic system having a function of accurately detecting a sign of a failure of a semiconductor component 20. A semiconductor diagnostic system 100 includes: a semiconductor component 20 including a functional unit 21 that outputs a diagnosis target signal 22 for diagnosing a characteristic variation of a physical quantity; a reference generation unit 10 that outputs a reference signal 11 representing a physical quantity serving as a reference for diagnosing the characteristic variation; and a diagnosis unit 30 that detects the characteristic variation of the physical quantity represented by the diagnosis target signal 22. The diagnosis unit 30 outputs a comparison result between the physical quantity represented by the diagnosis target signal 22 and the physical quantity represented by the reference signal 11, and the reference generation unit 10 is disposed at a place where the reference generation unit 10 is affected by a smaller environmental influence than the semiconductor component 20. As a result, a sign of a failure of the semiconductor component 20 can be accurately detected.

## Description

### Technical Field

The present invention relates to a semiconductor diagnostic system for diagnosing a semiconductor component including an integrated circuit.

### Background Art

Automotive semiconductor components are generally required to have higher reliability than consumer products, and each semiconductor supplier performs mass production after ensuring reliability for automobiles. For example, 10-year or 200,000-kilometer warranty is provided for an automobile. These warranties include an idea unique to each automobile manufacturer, and an operating time of a semiconductor component per day is assumed to be several hours.

In addition, in recent years, the autonomous driving technology has been actively developed, and it is expected that, when the autonomous driving of Level 4 or higher is put into practical use, a driver will not need to operate, and a system mounted on a vehicle will perform a driving operation and all other operations.

Therefore, a technique for accurately detecting a failure of a semiconductor component used in a severe environment for automobiles is desired.

PTL 1 describes a circuit inspection apparatus capable of accurately inspecting an operation frequency of a circuit even when the operation frequency of the circuit formed in an integrated circuit is high.

### Citation List

### Patent Literature

PTL 1: JP 2005-326234 A

### Summary of Invention

### Technical Problem

As described above, the current concept of reliability of automotive semiconductor components includes an assumption of an operating time per day. This is based on that a human operates an automobile as a driver. In the future, it is expected that, when car sharing or fully autonomous driving is put into practical use, the operating time is close to 24 hours per day particularly in an extreme case where autonomous delivery or the like is taken into account.

In such a case, it is conceivable that the life of a semiconductor component, in other words, the failure occurrence time will be relatively considerably earlier than the failure occurrence time at present and may be about one or two years if the failure occurrence time is short.

Also for current automotive semiconductor components, designing is performed based on the reliability to withstand use assuming, for example, the above 10-year 200,000-kilometer driving; however, it is not realistic to provide reliability warranty for the 24-hour operation as described above in terms of feasibility and cost.

In addition, since a functional failure due to a failure of a component can be fatal in autonomous driving, it is desirable to grasp the failure before the failure occurs.

The technique described in PTL 1 can detect an occurrence of a failure, but cannot accurately detect a sign of the failure.

Furthermore, in a case where the technique described in PTL 1 is applied to inspection of a semiconductor component used in a severe environment for automobiles, an inspection target circuit and an equivalent circuit of the inspection target circuit are disposed on the same integrated circuit, and high accuracy of the equivalent circuit to be compared with the inspection target circuit cannot be reliably maintained for a long period of time, either; therefore, it cannot be expected to detect a sign of failure with high accuracy.

In view of the above, instead of attempting to guarantee the reliability of a single semiconductor component for a long time operation, a method of long-term guarantee including part replacement is also considered as a future option.

For that purpose, it is considered that the following issues will be objects: achieving a function for accurately detecting a sign of a failure of a semiconductor component; and providing a means for achieving such function with lower cost.

An object of the present invention is to achieve a low-cost semiconductor diagnostic system having a function of accurately detecting a sign of a failure of a semiconductor component.

### Solution to Problem

In view of the above problems, a semiconductor diagnostic system according to a claim of the present invention has the following configuration.

A semiconductor diagnostic system includes: a semiconductor component including a functional unit that outputs a diagnosis target signal for diagnosing a characteristic variation of a physical quantity; a reference generation unit that outputs a reference signal representing a physical quantity serving as a reference for diagnosing the characteristic variation; and a diagnosis unit that detects the characteristic variation of the physical quantity represented by the diagnosis target signal, wherein the diagnosis unit outputs a comparison result between the physical quantity represented by the diagnosis target signal and the physical quantity represented by the reference signal, and the reference generation unit is disposed at a place where the reference generation unit is affected by a smaller environmental influence than the semiconductor component.

### Advantageous Effects of Invention

When the semiconductor diagnostic system according to the present invention is used, it is possible to achieve a low-cost semiconductor diagnostic system having a function of accurately detecting a sign of a failure of a semiconductor component.

In addition, it is possible to accurately detect a variation from an initial characteristic with respect to a functional unit included in a semiconductor component mounted on a vehicle, to determine that there is a sign of failure when a variation amount of a characteristic increases, and to then issue an alarm, for example, in a form of a component replacement notification.

In addition, by installing a mechanism for correcting the functional unit, it is possible to further extend a period until component replacement, and the number of times of replacement is therefore reduced, thereby enabling cost reduction.

### Brief Description of Drawings

[FIG. 1] FIG. 1 is a diagram illustrating an example of a configuration of a semiconductor diagnostic system 100 according to a first embodiment.
[FIG. 2] FIG. 2 is a diagram illustrating an example of a configuration of a diagnosis unit 30 according to the first embodiment.
[FIG. 3] FIG. 3 is a time chart for describing an operation in which the semiconductor diagnostic system 100 detects a characteristic variation of a functional unit 21, in the first embodiment.
[FIG. 4] FIG. 4 is a diagram illustrating an example of a configuration of a semiconductor diagnostic system 100 according to a second embodiment.
[FIG. 5] FIG. 5 is a diagram illustrating an example of a configuration of a correction and storage unit 60 in the second embodiment.
[FIG. 6] FIG. 6 is a time chart for describing an operation in which the semiconductor diagnostic system 100 detects a characteristic variation of a functional unit 21, in the second embodiment.
[FIG. 7] FIG. 7 is a diagram illustrating an example of a configuration of a semiconductor diagnostic system 100 according to a third embodiment.
[FIG. 8] FIG. 8 is a diagnostic control flowchart of the semiconductor diagnostic system 100 according to the third embodiment.
[FIG. 9] FIG. 9 is a diagram illustrating an example of a configuration of a semiconductor diagnostic system 100 according to a fourth embodiment.
[FIG. 10] FIG. 10 is a diagnostic control flowchart of the semiconductor diagnostic system 100 according to the fourth embodiment.
[FIG. 11] FIG. 11 is a diagram illustrating an example of a configuration of a semiconductor diagnostic system 100 according to a fifth embodiment.

### Description of Embodiments

Embodiments of the present invention will be described with reference to the accompanying drawings.

Hereinafter, a description will be given to a semiconductor diagnostic system in which it is possible to accurately detect a variation from an initial characteristic with respect to a functional unit included in a semiconductor component mounted on a vehicle, to determine that there is a sign of a failure when a variation amount of a characteristic increases, and to then issue an alarm, for example, in a form of a component replacement notification.

In addition, by mounting a mechanism for correcting the functional unit, the semiconductor system of the present invention can further extend a period until component replacement and can therefore reduce the number of times of replacement, thereby enabling cost reduction.

### Embodiments

### (First embodiment)

In a first embodiment of the present invention, a semiconductor diagnostic system performing the following operation will be described. When a characteristic of a signal output from a functional unit in a semiconductor component varies with time due to external stress such as heat, a temporal variation amount is detected using a reference signal generated by a reference generation unit, and when the temporal variation amount is a predetermined value or more, a flag is set.

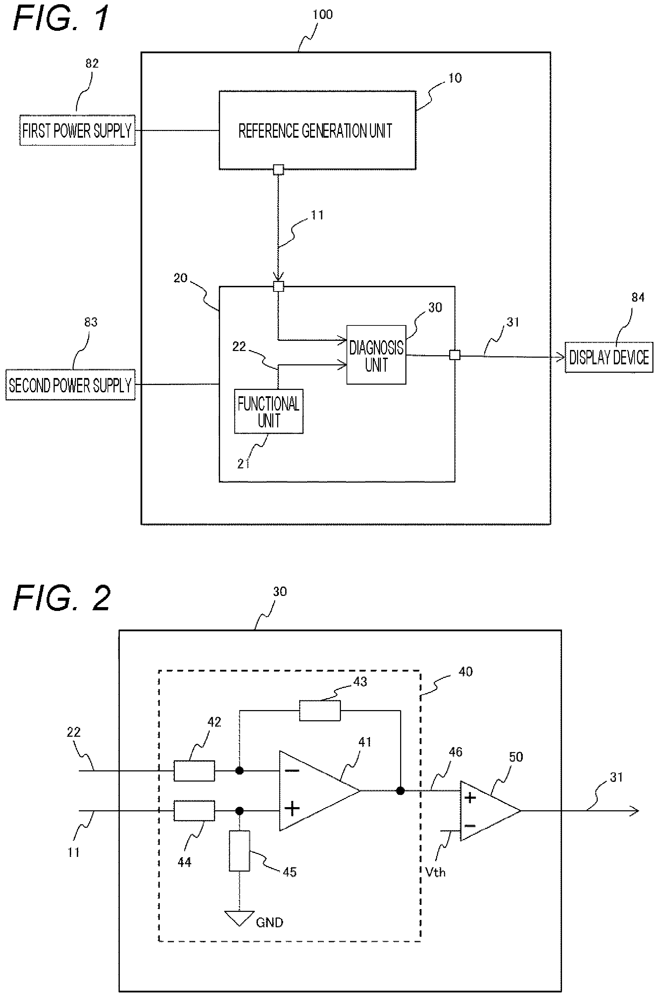

FIG. 1 is a block diagram illustrating an example of a configuration of a semiconductor diagnostic system 100 according to the first embodiment of the present invention. A semiconductor diagnostic system 100 according to the first embodiment of the present invention includes: a reference generation unit 10 that generates and outputs a reference signal 11 representing a physical quantity serving as a diagnostic reference; and a semiconductor component 20. The semiconductor component 20 includes: a functional unit 21 that outputs a diagnosis target signal 22; and a diagnosis unit 30 for performing a diagnosis by comparing the reference signal 11 and the diagnosis target signal 22.

As the reference generation unit 10, the following circuit may be considered, for example: a constant voltage circuit that outputs as the reference signal 11 a signal having a predetermined voltage value, one example of the constant voltage circuit being a bandgap reference circuit; or a constant current circuit that outputs as the reference signal 11 a signal having a predetermined current value, one example of the constant current circuit being a current mirror circuit. Alternatively, the reference generation unit 10 may also be an oscillation circuit that outputs as the reference signal 11 a signal oscillating at a predetermined frequency and is configured with one of or a combination of a crystal oscillator, a resistive element, an inductive element, and a capacitive element. Furthermore, the reference generation unit 10 may be configured such that one or more of the above-described constant voltage circuit, constant current circuit, and oscillation circuit are mounted, and one of the outputs is selected and output as the reference signal 11.

The functional unit 21 in the semiconductor component 20 may be, for example, a power supply circuit that outputs a predetermined voltage, a constant current circuit for supplying a reference current to another function disposed in the semiconductor component 20, or an oscillation circuit that generates a clock to be used in the semiconductor component 20.

The diagnosis unit 30 compares characteristics of the reference signal 11 having been input and the diagnosis target signal 22 to detect a difference, and diagnoses a characteristic variation of the semiconductor component 20 on the basis of the fact that the difference is larger than a predetermined threshold. The characteristics compared in the diagnosis unit 30 are a physical quantity of a waveform, and examples of the physical quantity include a voltage value, a current value, and a frequency. The diagnosis target signal 22 is a signal representing the characteristic of a physical quantity.

A first power supply 82 that supplies power from outside the semiconductor diagnostic system 100 is connected to the reference generation unit 10. In addition, a second power supply 83 that supplies power from outside the semiconductor diagnostic system 100 is connected to the semiconductor component 20.

The diagnosis unit 30 is connected to a display device (display unit) 84 outside the semiconductor diagnostic system 100.

As a circuit for detecting a difference of a characteristic, various circuits are considered, and one conceivable example of the diagnosis unit 30 for performing a diagnosis by comparing the voltage values in the first embodiment is a circuit including a subtraction circuit 40 and a comparator circuit 50 as illustrated in FIG. 2.

In FIG. 2, the simplest configuration of the subtraction circuit 40 includes an operational amplifier 41, four resistors 42 to 45, and a ground potential GND. The subtraction circuit 40 outputs as a difference signal 46 the difference between voltage values of the reference signal 11 and the diagnosis target signal 22, and the difference signal 46 is input to a comparator 50 in a subsequent stage. The comparator 50 compares a threshold voltage Vth set as the predetermined threshold with the difference signal 46, and outputs a diagnosis result 31 on the basis of the result of the comparison between the difference signal 46 and the threshold voltage Vth.

The diagnosis result 31 output from the comparator 50 is a logic high level (hereinafter, referred to as H level) or a logic low level (hereinafter, referred to as L level). In the first embodiment of the present invention, in the case where the voltage value of the difference signal 46 is larger than the threshold voltage Vth, the diagnosis result 31 is output at H level, and in other cases, the diagnosis result 31 is output at L level. The diagnosis result 31 is displayed on the display device 84.

The reference generation unit 10 and the semiconductor component 20 are disposed in different places that are affected differently by heat from the surroundings, separately by heat of their self-heating caused by power consumptions of their electrical operations. In one example, inside an automobile, the semiconductor component 20 is disposed under an engine hood, and the reference generation unit 10 is disposed in a vehicle cabin.

Under the engine hood, the semiconductor component 20 is exposed to a relatively higher temperature thermal environment than when disposed in the vehicle cabin, due to the following heat generation: heat generation due to operation of an internal combustion engine such as an engine in the case of an internal combustion engine vehicle; or heat generation due to operation of an inverter system for driving the vehicle in the case of an electric vehicle.

On the other hand, inside the vehicle cabin, which is exemplified as a place where the reference generation unit 10 is disposed, is set assuming that occupants are generally on board, and in most cases, temperature adjustment equipment such as an air conditioner is therefore provided for comfort or other purposes. In view of this fact, the temperature in the vehicle cabin can be expected to be relatively lower than the temperature in the engine room.

In addition, the semiconductor component 20 generally has, in addition to the functional unit 21, a mechanism for performing a functional operation, and the semiconductor component 20 generates heat due to such functions; therefore, the internal temperature of the semiconductor component 20 becomes higher in relation to the ambient temperature. On the other hand, the reference generation unit 10 does not need to have other functions and can be designed so as generate a relatively smaller heat amount than the semiconductor component 20.

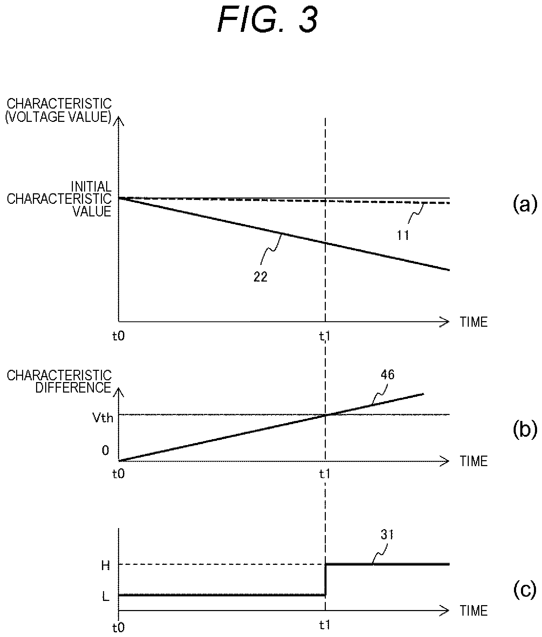

As a result of the above, in the first embodiment, the reference generation unit 10 is less affected by heat received from the surroundings than the semiconductor component 20. That is, the temporal variation amount of the physical quantity of the reference signal 11 is relatively smaller than the temporal variation amount of the physical quantity represented by the diagnosis target signal 22. With reference to FIG. 3, a description will be given to an operation in which the semiconductor diagnostic system 100 according to the first embodiment detects a characteristic variation of the functional unit 21 at this time.

Part (a) of FIG. 3 schematically illustrates how the characteristics (voltage values in the first embodiment) of the reference signal 11 (shown by a broken line) and the diagnosis target signal 22 (shown by a solid line) temporally vary.

In the semiconductor diagnostic system 100 of the first embodiment, it is assumed that the characteristic of the reference signal 11 and the voltage value of the diagnosis target signal 22 at time t0 represent initial characteristic values. As described above, in the first embodiment, the semiconductor component 20 and the functional unit 21, and the reference generation unit 10 are disposed at places having different thermal influences, and the semiconductor component 20 is assumed to be disposed at a place where the temperature becomes higher.

In general, it is known that variations in characteristics of semiconductor elements and semiconductor integrated circuits using the semiconductor elements are accelerated irreversibly by a chemical reaction or the like inside the semiconductor integrated circuit in accordance with an operating time under a higher temperature condition.

Part (b) of FIG. 3 temporally illustrates a detection value of the difference signal 46. A difference value between the characteristic of the reference signal 11 and the characteristic of the diagnosis target signal 22 is output to the difference signal 46. At time t1, when the voltage value represented by the difference signal 46 becomes equal to or exceeds the threshold Vth set at the comparator 50, the output of the diagnosis result 31 changes from L level to H level as illustrated in part (c) of FIG. 3.

Although not particularly described in the first embodiment, if there is provided a mechanism in which any of the system in the vehicle detects that the diagnosis result 31 has changed to H level, it is possible to notify a user of an automobile or the like that the semiconductor component 20 needs to be replaced.

Note that, in the first embodiment, it is assumed that the reference generation unit 10 and the semiconductor component 20 are disposed at different places that are affected by different thermal influences. However, different arrangements may be considered with respect to the applied voltage and the humidity at the place where the semiconductor is used, considering the applied voltage and the humidity as a cause of a characteristic variation of a semiconductor.

It should be noted that the example of the diagnosis unit 30 is merely an example written from the viewpoint of comparison of voltage values and that a similar difference detection function can be realized in various other forms. For example, it is possible to use a current input type comparator circuit for comparing current values, or it is possible to use a circuit for comparing frequencies such as a digital counter or a phase comparator.

In addition, inside the diagnosis unit 30 or in the preceding step of comparison before being input, the comparison may be performed in an analog value or may be performed after being converted into digital values.

It is possible to consider a method in which a determination value for the characteristic variation, which is written as "threshold voltage Vth" in the first embodiment, is set assuming, on the basis of the initial characteristic, a variation rate and a variation amount of an absolute value. However, for example, in the constant voltage source as described in the first embodiment, there are determined requirements for a power supply voltage also with respect to a component to which the voltage is supplied, and a method may be considered in which the determination value is determined on the basis of the requirements.

The determination value for the characteristic variation may be output by a predetermined electronic circuit so as to represent a predetermined value in the diagnosis unit 30, or may be output by a storage element such as a register or a memory having a mechanism in which numerical information can be written.

From the above, an operation of the semiconductor diagnostic system 100 has become clear, and the semiconductor diagnostic system 100 is characterized as follows: the reference generation unit 10 is disposed at a place where a thermal influence is different from the thermal influence that affects the semiconductor component 20 including the functional unit 21, so that the temporal characteristic variation of the reference generation unit 10 is smaller than that of the functional unit 21, which is the diagnosis target.

The first embodiment of the present invention makes it possible to achieve the semiconductor diagnostic system 100 that has a function of accurately detecting a sign of a failure of the semiconductor component 20 and is low in cost.

In the first embodiment of the present invention, the failure diagnosis is can be configured such that the diagnosis is not made only by a single diagnosis result but the diagnosis result is obtained by a plurality of times of diagnoses. For example, it may be determined that there is a sign of failure when it is diagnosed by three consecutive diagnoses that there is a sign of failure. This is to consider that there is a possibility of noise being generated at the time of diagnosis.

### (Second embodiment)

Next, a second embodiment of the present invention will be described.

In the second embodiment of the present invention, a semiconductor diagnostic system 100 will be described. The semiconductor diagnostic system 100 detects, when a characteristic of a signal output from a functional unit 21 in a semiconductor component 20 varies with time due to external stress such as heat, a temporal variation amount using a reference signal generated by a reference generation unit 10; the semiconductor diagnostic system 100 includes a correction and storage unit 60 that corrects a characteristic of the functional unit 21 on the basis of the temporal variation amount; and the semiconductor diagnostic system 100 set a flag when the temporal variation amount becomes a predetermined value or more.

Hereinafter, the differences from the first embodiment of the present invention will be described, and the overlapping parts will not be described. The first power supply 82, the second power supply 83, and the display device 84 illustrated in FIG. 1 are not illustrated. In addition, similarly to the first embodiment of the present invention, in the second embodiment, the reference generation unit 10 is assumed to be less affected by heat received from the surroundings than the semiconductor component 20.

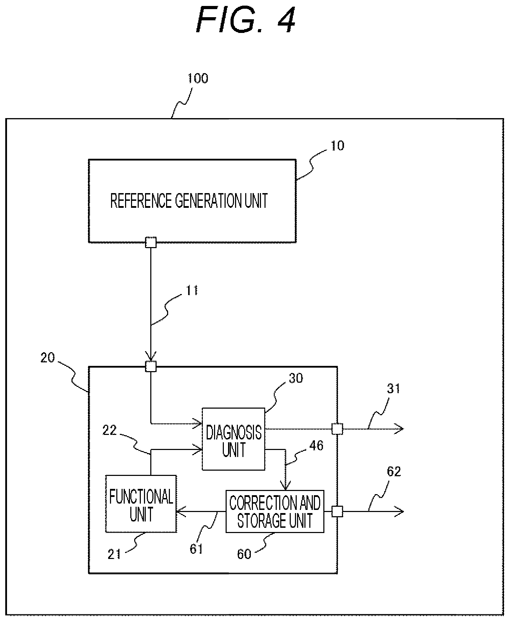

FIG. 4 is a block diagram illustrating an example of a configuration of the semiconductor diagnostic system 100 according to the second embodiment of the present invention. Focusing on the differences from the first embodiment of the present invention, the semiconductor diagnostic system 100 further includes a correction and storage unit 60 in order to correct the characteristic of the functional unit 21 on the basis of a difference signal 46 detected in the diagnosis unit 30 and in order for the functional unit 21 to store the corrected amount.

The correction and storage unit 60 corrects the characteristic of the functional unit 21 on the basis of the difference signal 46 and stores a cumulative correction amount. In addition, when the cumulative correction amount reaches a predetermined amount, the correction and storage unit 60 outputs a correction limit notification.

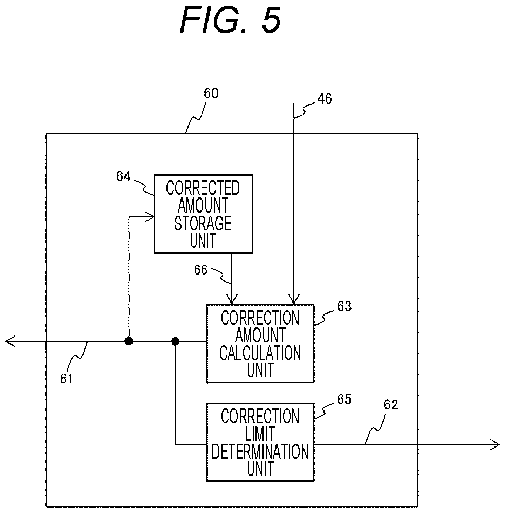

FIG. 5 illustrates an example of the configuration of the correction and storage unit 60. The correction and storage unit 60 in the second embodiment includes: a correction amount calculation unit 63 that outputs a correction amount instruction signal 61 on the basis of the difference signal 46 and a corrected amount 66; a corrected amount storage unit 64 that stores, as a new corrected amount, information of the correction amount instruction signal 61 when the correction amount instruction signal 61 has been changed; and a correction limit determination unit 65 that determines whether a value represented by the correction amount instruction signal 61 is within a correctable range of the functional unit 21, that outputs H level to a correction limit notification 62 when the value exceeds the correctable limit, and that outputs L level when the value does not exceed the correctable range.

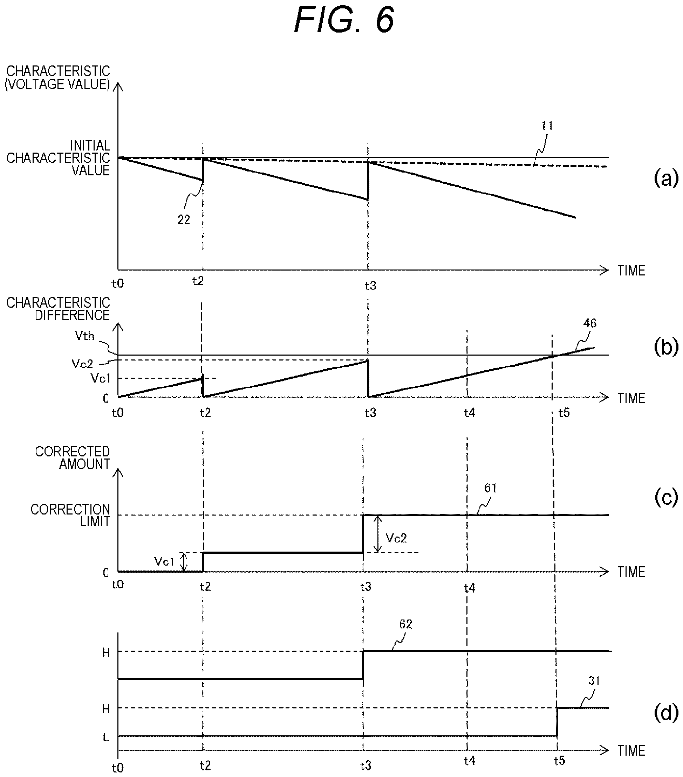

With reference to parts (a) to (d) of FIG. 6, an operation will be described in which the semiconductor diagnostic system 100 in the second embodiment detects a characteristic variation of the functional unit 21 and corrects the characteristic of the functional unit 21.

Part (a) of FIG. 6 schematically illustrate how the characteristics (voltage values in the second embodiment) of the reference signal 11 and the diagnosis target signal 22 temporally vary. In the semiconductor diagnostic system 100 of the second embodiment, it is assumed that the characteristic of the reference signal 11 and the voltage value of the diagnosis target signal 22 at time t0, which is a certain point of time, represent initial characteristic values. In the second embodiment, the semiconductor component 20 and the functional unit 21, and the reference generation unit 10 are disposed at places having different thermal influences, and the semiconductor component 20 is assumed to be disposed at a place where the temperature becomes higher.

Part (b) of FIG. 6 temporally illustrates the detection value of the difference signal 46. Part (c) of FIG. 6 illustrates a value of the correction amount instruction signal 61 for correcting the characteristic of the functional unit 21. A difference value between the characteristic of the reference signal 11 and the characteristic of the diagnosis target signal 22 is output to the difference signal 46. In the semiconductor diagnostic system 100 of the second embodiment, it is assumed that the characteristic of the reference signal 11 and the voltage value of the diagnosis target signal 22 at time t0 represent the initial characteristic values and that the characteristic of the functional unit 21 is not corrected, so that the corrected amount 66 is zero. Times t2, t3, and t4 represents examples of the times at which the diagnosis unit 30 diagnoses the characteristic variation.

When the result of the characteristic variation diagnosis performed by the diagnosis unit 30 at time t2 shows that the voltage value represented by the difference signal 46 is Vc1 (< Vth), the value Vc1 of the difference signal 46 is input to the correction and storage unit 60 at this point of time. As described above, the corrected amount 66 is zero at time t0, and the correction amount instruction signal 61 at and after time t2 is calculated, at time t2, by the correction amount calculation unit 63 from the difference signal 46 and the corrected amount 66.

At time t2 in the second embodiment, the correction amount instruction signal 61 is updated from 0 to Vc1. On the basis of the value of the correction amount instruction signal 61, the characteristic of the functional unit 21 is corrected, so that the characteristic of the diagnosis target signal 22 matches the characteristic of the reference signal 11 as illustrated at time t2 in part (a) of FIG. 6.

Next, when the result of the characteristic variation diagnosis performed by the diagnosis unit 30 at time t3 shows that the voltage value represented by the difference signal 46 is Vc2 (< Vth), the value Vc2 of the difference signal 46 is input to the correction and storage unit 60 at this point of time. The corrected amount 66 was updated to Vc1 at time t2, and the correction amount instruction signal 61 at and after time t2 is calculated, at time t3, by the correction amount calculation unit 63 from the difference signal 46 and the corrected amount 66.

At time t3 in the second embodiment, the correction amount instruction signal 61 is updated from 0 to Vc1+Vc2. On the basis of the value of the correction amount instruction signal 61, the characteristic of the functional unit 21 is corrected, so that the characteristic of the diagnosis target signal 22 matches the characteristic of the reference signal 11 as illustrated at time t3 in part (a) of FIG. 6.

In the second embodiment, it is assumed that when the corrected amount 66 is updated to Vc1 + Vc2 at time t3, the corrected amount 66 has reached a correctable upper limit, in other words, a correction limit of the functional unit 21.

In general, for correcting a characteristic, an analog system whose input is analog voltage or a digital system whose input is a bus signal is used, and the correction limit is determined by a range of a voltage that can be input in the case of the analog system or by a range that can be expressed in binary form in accordance with the number of bits. The correction limit determination unit 65 detects the correction limit on the basis of the analog voltage input or the binary representation of the bus signal, and outputs H level to the correction limit notification 62 as illustrated in part (d) of FIG. 6.

Furthermore, consider a case where a characteristic variation diagnosis is performed by the diagnosis unit 30 at time t4. At this time, the correction range of the functional unit 21 have reached the upper limit, and even if the difference signal 46 takes a positive value other than 0, no further correction is performed. In addition, at time t4, the difference signal is less than Vth, and L level is output as the diagnosis result 31 of the characteristic variation as illustrated in part (d) of FIG. 6.

When the value of the difference signal 46 reaches Vth at time t5, the diagnosis unit 30 diagnoses that the functional unit 21 has caused a characteristic variation, and H level is output to the diagnosis result 31 as illustrated in part (d) of FIG. 6. Similarly to the first embodiment, if there is provided a mechanism in which any of the system in the vehicle, such as the display device 84 illustrated in FIG. 1, detects that the diagnosis result 31 has changed to H level, it is possible to notify a user of an automobile or the like that the semiconductor component 20 needs to be replaced. In addition, the correction limit notification 62 in which H level is output at time t3 can be used as a further pre-notification of the replacement notification to the user, which is triggered when the diagnosis result 31 is output to be H level.

Considering that the characteristic variation of the functional unit 21 progresses at the same speed in the first embodiment and the present embodiment (second embodiment), it can be easily imagined that, of (i) time t1 at which H level is output to the diagnosis result 31 of the functional unit 21 in the first embodiment and (ii) time t5 at which H level is output to the diagnosis result 31 of the functional unit 21 in the second embodiment, time t5 comes after time t1.

That is, in the second embodiment, the same effects as those in the first embodiment can be obtained, and in addition, the semiconductor component 20 and the functional unit 21 in the semiconductor diagnostic system 100 can be used for a longer period as compared with the first embodiment, and for example, it is possible to obtain an effect that the timing of component replacement in an automobile can be longer.

From the above, an operation of the semiconductor diagnostic system 100 has become clear, and the semiconductor diagnostic system 100 is characterized as follows: the reference generation unit 10 is disposed at a place where a thermal influence is different, so that the temporal characteristic variation of the reference generation unit 10 is smaller than that of the functional unit 21, which is the diagnosis target.

### (Third embodiment)

Next, a third embodiment of the present invention will be described.

The third embodiment of the present invention will describe an operation of the semiconductor diagnostic system 100 in which a single reference generation unit 10 is shared by a plurality of semiconductor components 20-1 to 20-n, so that the diagnosis of a characteristic variation can be performed while reducing the number of components and suppressing an increase in cost.

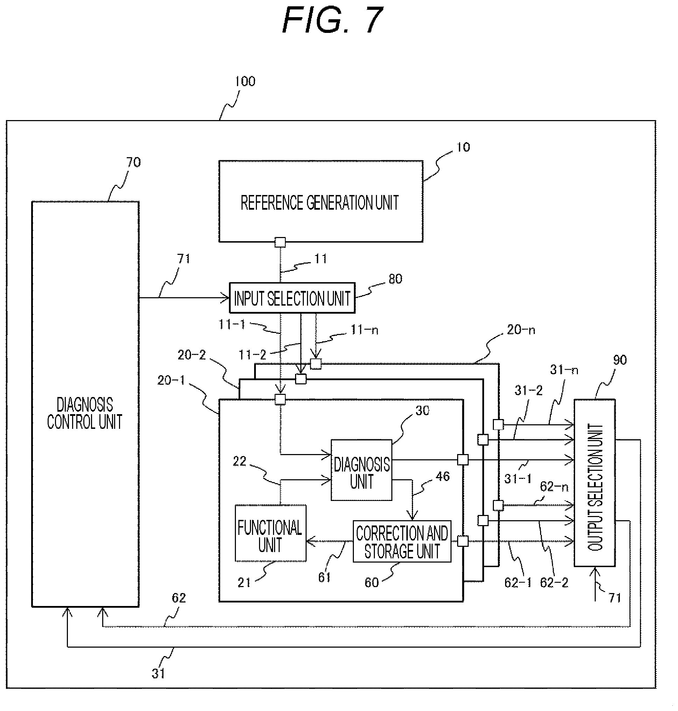

FIG. 7 is a block diagram illustrating an example of a configuration of a semiconductor diagnostic system 100 according to the third embodiment of the present invention. The first power supply 82, the second power supply 83, and the display device 84 are not illustrated. Focusing on the differences from the second embodiment of the present invention, the semiconductor diagnostic system 100 further includes: a plurality of the semiconductor components 20-1 to 20-n (n is an integer of 2 or more); and a diagnosis control unit 70 that outputs a diagnosis control signal 71 for selectively designating any one of the plurality of semiconductor components 20-1 to 20-n that will be a diagnosis target so as to selectively perform a diagnosis operation on the selected semiconductor component.

In addition, the semiconductor diagnostic system 100 includes: an input selection unit 80 for selectively outputting a reference signal 11 to one of the plurality of semiconductor components 20-1 to 20-n in accordance with the diagnosis control signal 71 from the diagnosis control unit 70; and an output selection unit 90 for selecting one of diagnosis results 31-1 to 31-n output from the plurality of semiconductor components 20-1 to 20-n and one of correction upper limit notifications 62-1 to 62-n and for outputting the selected ones to the diagnosis control unit 70.

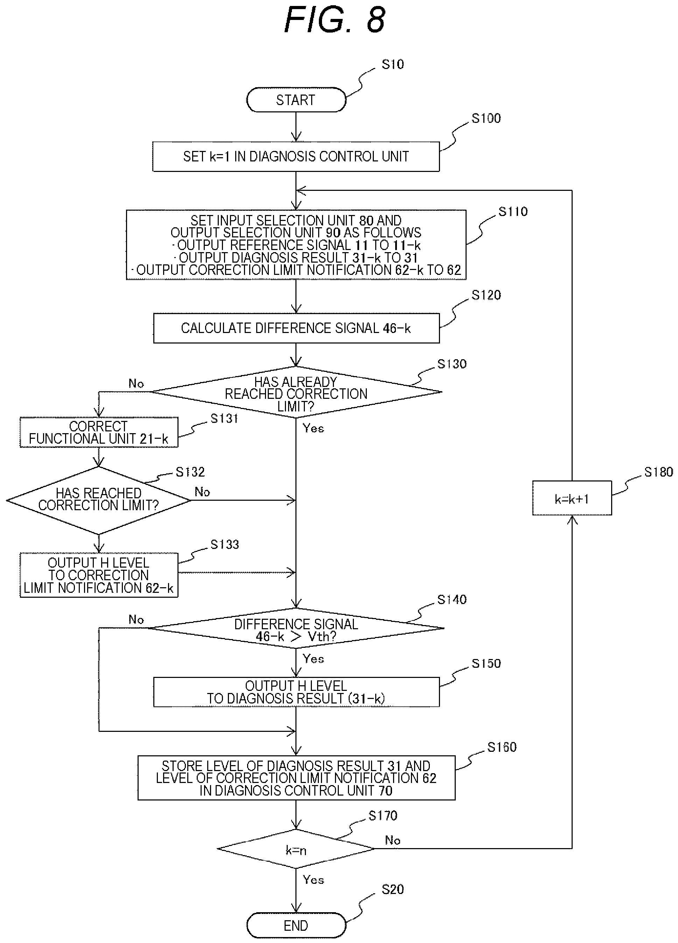

A diagnosis operation performed on the selected semiconductor component has a content similar to that described in the second embodiment, and a content of control on the plurality of semiconductor components by the diagnosis control unit 70 in the third embodiment will be described with reference to the flowchart of FIG. 8.

After the flow is started in step S10 of the flowchart of FIG. 8, first, in step S100, a variable for selecting one of the plurality of semiconductor components 20-1 to 20-n is set in the diagnosis control unit 70. In the third embodiment, a variable k is used to select the k-th semiconductor component 20-k.

In step S110, the input selection unit 80 and the output selection unit 90 are set on the basis of the content set to the variable k. Specifically, control is performed such that the reference signal 11, the diagnosis result 31, and the correction limit notification 62 are respectively connected to the reference signal 11-k, the diagnosis result 31-k, and the correction limit notification 62-k so that the reference signal 11, the diagnosis result 31, and the correction limit notification 62 are input to or output from the k-th semiconductor component 20-k.

The flow from step S120 to step S150 performs, with respect to the k-th semiconductor component 20-k and the functional unit 21, the content described in the second embodiment, and the description of the flow will be omitted. The results obtained by completing the flow up to step S150 are the diagnosis result 31 and the correction limit notification 62. In step S160, the diagnosis control unit 70 receives those signals and stores whether each signal is at H level or L level.

In step S170, it is determined whether the characteristic variation diagnosis for the n-th semiconductor component 20-n has been completed, and if Yes, the process proceeds to step S20, and the flow is completed. If No, the flow proceeds to step S180 to increment k, and the flow then proceeds again to step S110.

The third embodiment makes it possible to achieve the semiconductor diagnostic system 100 that can diagnose the characteristic variation for the plurality of semiconductor components 20-1 to 20-n similarly to the second embodiment and can diagnose the characteristic variation while reducing the number of components and suppressing an increase in cost.

The above description has described an operation of the semiconductor diagnostic system 100 in which a single reference generation unit 10 is shared by a plurality of semiconductor components 20-1 to 20-n, so that the diagnosis of a characteristic variation can be performed while reducing the number of components and suppressing an increase in cost.

### (Fourth embodiment)

Next, a fourth embodiment of the present invention will be described.

The fourth embodiment of the present invention will describe an operation of a semiconductor diagnostic system 100 in which a diagnosis unit 30, which is mounted on each of the plurality of semiconductor components 20-1 to 20-n in the third embodiment, is disposed outside and shared by the semiconductor components 20-1 to 20-n, so that the diagnoses of a characteristic variation can be performed while reducing variation and component cost.

In the example in the block diagram of the diagnosis unit 30 described in the first embodiment, the operational amplifier 41 and the resistance elements 42 to 45 are illustrated as the subtraction circuit 40. When these components are mounted on each of the semiconductor components 20-1 to 20-n, the diagnosis accuracy of the diagnosis units 30 varies among the semiconductor components 20-1 to 20-n due to the input offset voltages of the operational amplifiers 41 at the time of producing the semiconductor components and due to the accuracy variation of the resistance elements 42 to 45.

In the fourth embodiment, an object is to perform a characteristic diagnosis such that the diagnosis unit 30 is disposed outside the semiconductor components 20-1 to 20-n so as to be shared by the semiconductor components 20-1 to 20-n so that the characteristic is diagnosed while eliminating variation of the diagnosis accuracy.

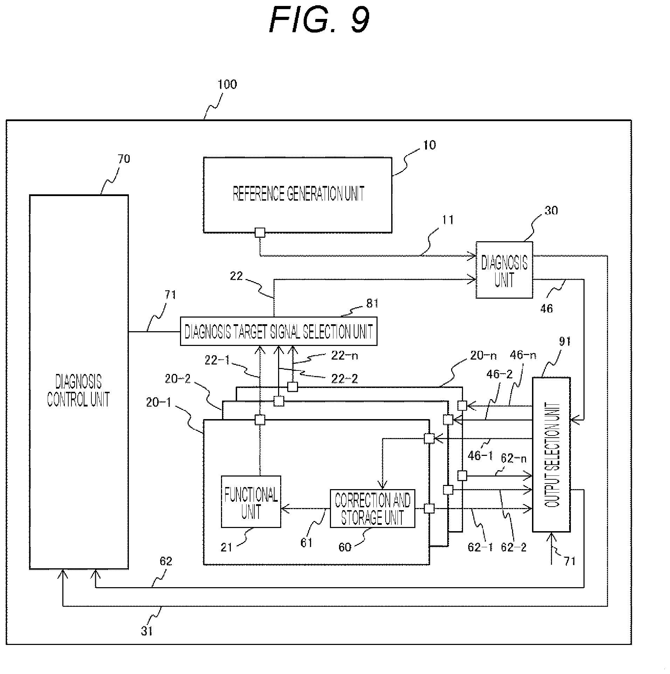

FIG. 9 is a block diagram illustrating an example of a configuration of a semiconductor diagnostic system 100 according to the fourth embodiment of the present invention. The first power supply 82, the second power supply 83, and the display device 84 are not illustrated. Focusing on the differences between the third embodiment and the fourth embodiment of the present invention, a diagnosis unit 30 is included in each of the plurality of semiconductor components 20-1 to 20-n in the third embodiment, but a single diagnosis unit 30 is disposed outside the semiconductor components 20-1 to 20-n.

In addition, the semiconductor diagnostic system 100 includes: a diagnosis target signal selection unit 81 for directly inputting a reference signal 11 to the diagnosis unit 30, selecting one of diagnosis target signals 22-1 to 22-n from the plurality of semiconductor components 20-1 to 20-n, and inputting the selected diagnosis target signal to the diagnosis unit 30; and an output selection unit 91 for selectively inputting a difference signal 46 calculated in the diagnosis unit 30 to the plurality of semiconductor components 20-1 to 20-n, selecting one of correction upper limit notifications 62-1 to 62-n output from the plurality of semiconductor components 20-1 to 20-n, and outputting the selected one to a diagnosis control unit 70.

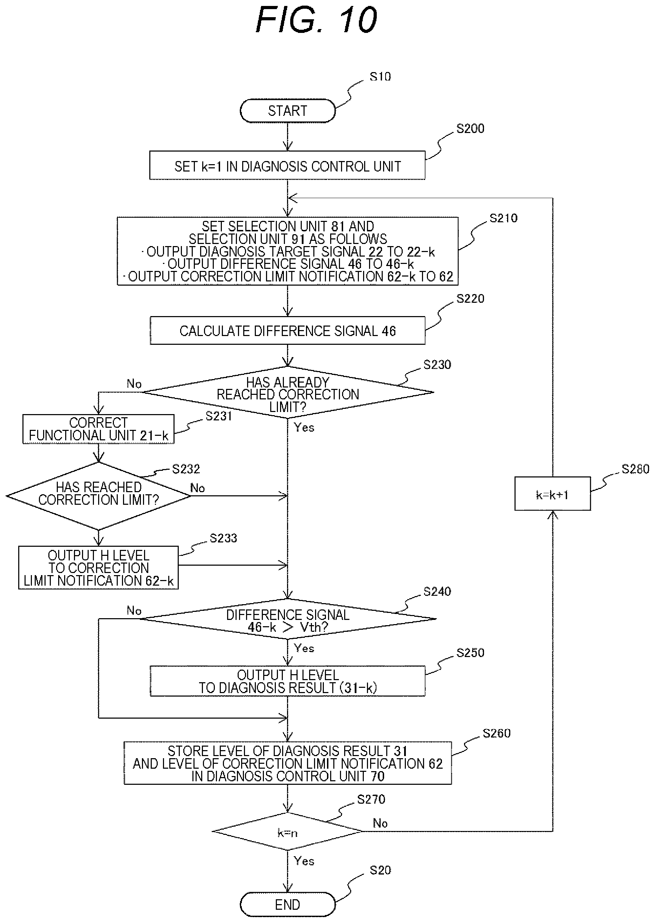

Hereinafter, with reference to the flowchart of FIG. 10, a description will be given to the content of control with respect to the plurality of semiconductor components 20-1 to 20-n performed by the diagnosis control unit 70 in the fourth embodiment.

After the flow is started in step S10 of the flowchart of FIG. 10, first, in step S200, a variable for selecting one of the plurality of semiconductor components 20-1 to 20-n is set in the diagnosis control unit 70.

In step S210, the diagnosis target signal selection unit 81 and the output selection unit 91 are set on the basis of the content set to the variable k. Specifically, control is performed such that the diagnosis target signal 22, the difference signal 46, and the correction limit notification 62 are respectively connected to the diagnosis target signal 22-k, the difference signal 46-k, and the correction limit notification 62-k so that the diagnosis target signal 22, the difference signal 46, and the correction limit notification 62 are input to or output from the k-th semiconductor component 20-k.

The flow from step S220 to step S250 is the same as the content described in the third embodiment, and the description of the flow will be omitted. The results obtained by completing the flow up to step S250 are the diagnosis result 31 and the correction limit notification 62. In step S260, the diagnosis control unit 70 receives those signals and stores whether each signal is at H level or L level.

In step S270, it is determined whether the characteristic variation diagnosis for the n-th semiconductor component 20-n has been completed, and if Yes, the process proceeds to step S20, and the flow is completed. If No in step S270, the flow proceeds to step S280 to increment k, and the flow then proceeds again to step S210.

In the fourth embodiment, since the diagnosis unit 30 is disposed outside the semiconductor components 20-1 to 20-n and is shared, it is possible to obtain an effected similar to that of the third embodiment, and, in addition, it is possible to achieve the semiconductor diagnostic system 100 that can diagnose a characteristic variation while reducing variations and component costs.

The above description has described an operation of the semiconductor diagnostic system 100 in which the diagnosis unit 30 is disposed outside the semiconductor components so as to be shared and a characteristic variation can be diagnosed while reducing variations and component cost.

### (Fifth embodiment)

Next, a fifth embodiment of the present invention will be described.

In the fifth embodiment of the present invention, a description will be given to a semiconductor diagnostic system 100 in a case where the reference generation unit 10 is particularly disposed outside a vehicle and the semiconductor component 20 is disposed inside the vehicle.

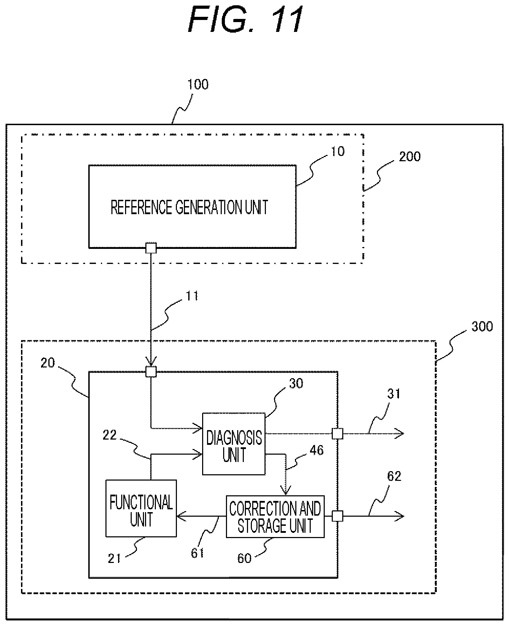

FIG. 11 is a block diagram illustrating an example of a configuration of a semiconductor diagnostic system 100 according to the fifth embodiment of the present invention. The first power supply 82, the second power supply 83, and the display device 84 are not illustrated. FIG. 11 is based on FIG. 4 illustrating an example of the configuration of the semiconductor diagnostic system 100 in the second embodiment.

In the second embodiment, similarly to the first embodiment, the reference generation unit 10 is characterized by being disposed at a place where the reference generation unit 10 is affected by a thermal influence different from a thermal influence that affects the semiconductor component 20. In the fifth embodiment, a description is given assuming that the reference generation unit 10 is disposed in a vehicle-external device or a vehicle-external facility 200 while the semiconductor component 20 is disposed inside a vehicle 300.

Examples of the vehicle-external device or the vehicle-external facility 200 includes various things, and one example thereof is charging facility for electric vehicles or plug-in hybrid vehicles. Advantage of disposing the reference generation unit 10 in the charging facility is as follows. The influence of heat can be reduced as compared with the case of disposing the reference generation unit 10 on the vehicle 300, and when a correction function for the reference generation unit 10 is provided in the charging facility, the reference signal 11 representing a desired characteristic can be always output.

In addition, since charging of the electric vehicle is an operation that can occur in association with traveling of the vehicle 300, when a characteristic variation diagnosis is set to be performed at the time of charging, it is also possible to perform a periodic diagnosis at the time of charging.

As a means for supplying the reference signal 11 to the semiconductor component 20, the reference signal 11 is preferably supplied via a charging cable.

Furthermore, as another example, there is no problem if the reference generation unit 10 is disposed in a facility for supplying gasoline, liquefied natural gas, hydrogen, or the like, and it is also possible to enable a driver of an automobile to perform a characteristic variation diagnosis simultaneously with a supply operation.

Furthermore, in another example, there is an example in which the reference generation unit 10 is disposed in a diagnosis machine for a vehicle. A periodic characteristic variation diagnosis of the semiconductor component 20 and the functional unit 21 can be performed by performing a characteristic variation diagnosis of the semiconductor component 20 when the diagnosis machine for a vehicle is connected to the vehicle 300 at the time of a legal inspection of the vehicle 300 or the like in order to check whether data is accumulated in an electronic control unit.

The content of the above description refers to the disposition of the reference generation unit 10, and the characteristic variation diagnosis can be performed according to the content described in the first to fourth embodiments.

According to the fifth embodiment, the reference generation unit 10 is disposed in the vehicle-external device or the vehicle-external facility 200, and the semiconductor component 20 is disposed in the vehicle; therefore, effects similar to those of the second embodiment can be obtained, and, in addition, there is an effect that influence of heat can be reduced as compared with the case where the reference generation unit 10 is disposed on the vehicle 300. Furthermore, by providing a correction function for the reference generation unit 10 in a vehicle-external device or a vehicle-external facility 200, the reference signal 11 representing a desired characteristic can be output at the time of using the vehicle-external device or the vehicle-external facility 200, so that it is possible to detect a sign of a failure of the semiconductor component 20.

In the above, a description has been given to the semiconductor diagnostic system 100 in the case where the reference generation unit 10 is particularly disposed outside the vehicle.

Note that, in the semiconductor diagnostic systems of the first to fourth embodiments described above, the semiconductor component 20 can be disposed outside the vehicle cabin of a vehicle, and the reference generation unit 10 can be disposed inside the vehicle cabin.

In addition, in the above-described examples, the semiconductor component 20 and the reference generation unit 10 are disposed at places having different thermal influences, but an example in which the semiconductor component 20 and the reference generation unit 10 are disposed at places having different influences of humidity is also included in other examples. The thermal influence and the influence of humidity can be collectively referred to as environmental influence.

As another embodiment of the present invention, the following example will be described.

A semiconductor system includes: a semiconductor component 20 including a functional unit 21 that outputs a diagnosis target signal 22 for diagnosing a characteristic variation of a physical quantity; a reference generation unit 10 that outputs a reference signal 11 representing a physical quantity serving as a reference for diagnosing the characteristic variation; a diagnosis unit 30 that detects the characteristic variation of the physical quantity represented by the diagnosis target signal 22; a first power supply 82 that supplies power to the reference generation unit 10; and a second power supply 83 that supply power to the semiconductor component 20, wherein the diagnosis unit 30 outputs a comparison result between the physical quantity represented by the diagnosis target signal 22 and the physical quantity represented by the reference signal 11, and the first power supply 82 is disposed at a place where first power supply 82 is affected by a smaller environmental influence than the second power supply 83.

### Reference Signs List

- 100: semiconductor diagnostic system
- 10: reference generation unit
- 11: reference signal
- 20, 20-1 to 20-n: semiconductor component
- 21: functional unit
- 22: diagnosis target signal
- 30: diagnosis unit
- 31, 31-1 to 31-n: diagnosis result
- 40: subtraction circuit
- 41: operational amplifier
- 42 to 45: resistance element
- 46: difference output
- GND: ground potential
- 50: comparator
- Vth: characteristic variation diagnosis threshold
- 60: correction and storage unit
- 61: correction amount instruction signal
- 62: correction limit notification
- 63: correction amount calculation unit
- 64: corrected amount storage unit
- 65: correction limit determination unit
- 66: corrected amount
- 70: diagnosis control unit
- 71: diagnosis control signal
- 80: input selection unit
- 81: diagnosis target signal selection unit
- 82: first power supply
- 83: second power supply
- 84: display device
- 90, 91: output selection unit
- 200: vehicle-external device or vehicle-external facility
- 300: vehicle

## Claims

1. A semiconductor diagnostic system comprising:
a semiconductor component including a functional unit that outputs a diagnosis target signal for diagnosing a characteristic variation of a physical quantity;
a reference generation unit that outputs a reference signal representing a physical quantity serving as a reference for diagnosing the characteristic variation; and
a diagnosis unit that detects the characteristic variation of the physical quantity represented by the diagnosis target signal,
wherein
the diagnosis unit outputs a comparison result between the physical quantity represented by the diagnosis target signal and the physical quantity represented by the reference signal, and
the reference generation unit is disposed at a place where the reference generation units is affected by a smaller environmental influence than the semiconductor component.

2. The semiconductor diagnostic system according to claim 1, further comprising a display unit,
wherein, when a difference obtained by comparing the physical quantity of the diagnosis target signal with the physical quantity of the reference signal is larger than a predetermined value, the diagnosis unit outputs a diagnosis result indicating that there is a sign of abnormality, and displays the diagnosis result on the display unit.

3. The semiconductor diagnostic system according to claim 1, wherein a temporal variation amount of the physical quantity of the reference signal is relatively smaller than a temporal variation amount of the physical quantity represented by the diagnosis target signal.

4. The semiconductor diagnostic system according to claim 1, further comprising a correction and storage unit,
wherein
the diagnosis unit further outputs, as a difference signal, a difference of the physical quantity of the diagnosis target signal with respect to the physical quantity represented by the reference signal,
the correction and storage unit corrects a characteristic of the functional unit, based on the difference signal, and stores a cumulative correction amount, and
the correction and storage unit outputs a correction limit notification when the cumulative correction amount reaches a predetermined amount.

5. The semiconductor diagnostic system according to claim 4, further comprising:
a plurality of the semiconductor components; and
a diagnosis control unit that outputs a diagnosis control signal designating any one semiconductor component of the plurality of the semiconductor components that is to be diagnosed.

6. The semiconductor diagnostic system according to claim 5, further comprising:
an input selection unit that outputs, in accordance with the diagnosis control signal output from the diagnosis control unit, the reference signal output from the reference generation unit to the any one semiconductor component of the plurality of the semiconductor components that is to be diagnosed; and
an output selection unit that selects one of a plurality of diagnosis results output from the plurality of the semiconductor components and outputs the selected diagnosis result to the diagnosis control unit.

7. The semiconductor diagnostic system according to claim 5, further comprising:
a diagnosis target signal selection unit that selects, in accordance with the diagnosis control signal output from the diagnosis control unit, any one semiconductor component of the plurality of the semiconductor components that is to be diagnosed, and that outputs the diagnosis target signal to the diagnosis unit; and
an output selection unit that outputs the difference signal output from the diagnosis unit to the correction and storage unit of the selected one semiconductor component of the plurality of the semiconductor components, and outputs a correction limit notification output from the correction and storage unit of the selected one semiconductor component of the plurality of the semiconductor components to the diagnosis control unit,
wherein the diagnosis unit is shared by the plurality of the semiconductor components, and a diagnosis result is output from the diagnosis unit to the diagnosis control unit.

8. A semiconductor diagnostic system for a vehicle, wherein, in the semiconductor diagnostic system according to claim 1, the semiconductor component is disposed outside a vehicle cabin of a vehicle, and the reference generation unit is disposed inside the vehicle cabin.

9. A semiconductor diagnostic system for a vehicle, wherein, in the semiconductor diagnostic system according to claim 1, the reference generation unit is disposed outside a vehicle, and the semiconductor component is disposed on the vehicle.

10. The semiconductor diagnostic system according to claim 1, wherein the environmental influence is a thermal influence.

11. The semiconductor diagnostic system according to claim 1, wherein the environmental influence is an influence of humidity.
